# EUROPEAN PATENT APPLICATION

(11) **EP 4 819 801 A1**
(43) Date of publication of application: **07.10.2026**
(21) Application number: 24902561.0
(22) Date of filing: 27.11.2024
(51) Int. Cl.: H10F 39/12, G01N 21/64

(54) **IMAGE SENSOR AND FORMING METHOD THEREFOR**

(30) Priority: 11.12.2023 CN 202311693435
(71) Applicant: Shenzhen Gate Biotech Co. Ltd, Guangdong 518057 (CN)
(72) Inventor: DAI, Chongchong, Shenzhen, Guangdong 518057 (CN); ZHANG, Qingyang, Shenzhen, Guangdong 518057 (CN); TAN, Haotian, Shenzhen, Guangdong 518057 (CN)
(74) Representative: KASTEL Patentanwälte PartG mbB
(86) International application number: PCT/CN2024/134814
(87) International publication number: WO 2025/124139

(57) **Abstract**

An image sensor and a forming method therefor. The method comprises: acquiring a substrate, having a first surface and a second surface which are opposite to each other, wherein the substrate is provided with a plurality of photoelectric sensing areas, and the first surface exposes the surfaces of the photoelectric sensing areas; forming a filter film on the photoelectric sensing areas, wherein the filter film allows for passing of an optical signal having a wavelength greater than a preset wavelength; and forming a first protective layer on the surface of the filter film. On one hand, an optical signal of a specific fluorescence band can be obtained by configuring the filter film, so that a fluorescence imaging experiment can be performed subsequently by means of such fluorescence band, thereby realizing lens-free imaging of a fluorescence signal, and simplifying the fluorescence microscopic detection process; on the other hand, the filter film is formed on the photoelectric sensing areas having a flat surface, so that the thicknesses of all positions of the filter film are uniform, thereby reducing the possibility of diffuse reflection and scattering of the fluorescence signal on the surface of the filter film caused by non-uniform thickness of the filter film, and ensuring the reliability of the fluorescence microscopic detection result.

## Description

This application claims priority to Chinese Patent Application No. 202311693435.4, titled "IMAGE SENSOR AND FORMING METHOD THEREFOR", filed on December 11, 2023 with the China National Intellectual Property Administration, which is incorporated herein by reference in its entirety.

### FIELD

The present disclosure relates to the field of semiconductor manufacturing technology, and in particular to an image sensor and a method for forming the same.

### BACKGROUND

Fluorescence imaging technology can monitor biomolecules, cells, tissues, and living organisms in real time and in multiple dimensions, and offer high-sensitivity output and high resolution. Fluorescence imaging has been widely used in disease diagnosis, drug distribution and metabolic assessment, and vascular bioimaging. Conventional fluorescence microscopic imaging systems are mainly fluorescence microscopes. Such traditional fluorescence microscopic imaging systems require rigorous optical path design, precision-machined optical components, and complex overall platform construction. Accordingly, traditional fluorescence microscopic imaging systems have long development cycles, expensive instruments, and large volumes. In addition, such fluorescence microscopic imaging systems require regular maintenance and calibration.

To overcome the shortcomings of traditional optical microscopic imaging, save the aforementioned complex optical path design and optical path system construction, and realize miniaturized imaging, simplified lens-free imaging technology has been adopted. The lens-free imaging technology is a high-throughput microscopic imaging technique that directly places a to-be-tested object on or close to a sensor surface for imaging without using any lenses. Instead of magnifying microscopic samples through lenses, the lens-free imaging relies on high-density pixel arrays to capture images of samples and then restores the images through digital image processing techniques. Since each tiny sensing pixel has a size similar to or smaller than that of a biological sample, high-sensitivity, high-resolution, and parallel detection can be achieved.

However, lens-free detection of fluorescence signals still suffers from many problems.

### SUMMARY

The technical problem solved by the present disclosure is to provide an image sensor and a method for forming the same, so as to realize lens-free detection of fluorescence signals.

To solve the above technical problem, a method for forming an image sensor is provided according to an embodiment of the present disclosure. The method includes: acquiring a substrate, where the substrate includes a first surface and a second surface opposite to each other, the substrate includes multiple photosensitive regions, and the first surface exposes surfaces of the photosensitive regions; forming an optical filter film on the multiple photosensitive regions, where the optical filter film allows an optical signal with a wavelength greater than a preset wavelength to pass through; and forming a first protective layer on a surface of the optical filter film.

In an embodiment, the substrate is a wafer substrate, and the method for acquiring the substrate includes: performing corresponding semiconductor process development on the wafer substrate to form the multiple photosensitive regions.

In an embodiment, the substrate is a discrete chip substrate, and the method for acquiring the substrate includes: providing an initial image sensor, where the initial image sensor includes the substrate, where the substrate includes a first surface and a second surface opposite to each other, the substrate includes multiple photosensitive regions, the first surface exposes surfaces of the multiple photosensitive regions; and a microlens structure located on the multiple photosensitive regions; and removing the microlens structure.

In an embodiment, the method further includes: forming a device layer on the first surface or the second surface of the substrate; and forming the optical filter film on a surface of the device layer.

In an embodiment, the method further includes: a device layer located on the first surface or the second surface of the substrate; and forming the optical filter film on a surface of the device layer.

In an embodiment, the substrate further includes an interconnection region surrounding the multiple photosensitive regions, and a surface of the interconnection region is provided with multiple interconnection lines.

In an embodiment, the initial image sensor further includes a first packaging structure covering the multiple interconnection lines and the microlens structure, and the first packaging structure includes a glass cover plate.

In an embodiment, before removing the microlens structure, the method further includes: removing the glass cover plate; where the method for removing the glass cover plate includes mechanical removal or thermal processing removal.

In an embodiment, after removing the glass cover plate and before removing the microlens structure, the method further includes: forming a second protective layer on surfaces of the multiple interconnection lines.

In an embodiment, after removing the glass cover plate and before forming the second protective layer, the method further includes: removing residual impurities of the glass cover plate.

In an embodiment, the method for removing the microlens structure includes one or a combination of mechanical grinding, chemical etching, and chemical mechanical polishing.

In an embodiment, after removing the microlens structure and before forming the optical filter film, the method further includes: cleaning surfaces of the multiple photosensitive regions.

In an embodiment, the method for forming the optical filter film includes: acquiring parameters of the optical filter film; and forming the optical filter film using the parameters of the optical filter film.

In an embodiment, the method for acquiring the parameters of the optical filter film includes: acquiring a required optical waveband, where optical parameters of the optical waveband include an excitation light source wavelength peak and an excitation light source wavelength bandwidth; acquiring an optical filter film material; and acquiring the parameters of the optical filter film based on the optical filter film material and the optical parameters, where the parameters of the optical filter film include a number of layers of the optical filter film and a thickness of the optical filter film.

In an embodiment, the method for forming the optical filter film includes spin coating of light-absorbing dye, magnetron sputtering of target material, or vapor deposition.

In an embodiment, after forming the optical filter film and before forming the first protective layer, the method further includes: forming a fiber optic plate microstructure on the surface of the optical filter film.

In an embodiment, the method for forming the fiber optic plate microstructure includes: forming an initial fiber optic plate microstructure on the surface of the optical filter film; and performing a micro-nano processing on the initial fiber optic plate microstructure to form the fiber optic plate microstructure.

In an embodiment, after forming the first protective layer, the method further includes: forming a second packaging structure on a surface of the first protective layer, where the second packaging structure includes a groove for carrying a to-be-tested sample.

Correspondingly, an image sensor is further provided according to an embodiment of the present disclosure. The image sensor includes: a substrate, where the substrate includes a first surface and a second surface opposite to each other, the substrate includes multiple photosensitive regions, and the first surface exposes surfaces of the multiple photosensitive regions; an optical filter film located on the multiple photosensitive regions, where the optical filter film allows an optical signal with a wavelength greater than a preset wavelength to pass through; and a first protective layer located on a surface of the optical filter film.

In an embodiment, the image sensor further includes: a device layer located on the first surface of the substrate or on the second surface of the substrate; where the optical filter film is located on a surface of the device layer.

In an embodiment, the image sensor further includes: a fiber optic plate microstructure located between the optical filter film and the first protective layer; where a material of the fiber optic plate microstructure includes silicon dioxide or titanium dioxide, and a thickness of the fiber optic plate microstructure ranges from 50 nm to 100 nm.

In an embodiment, the substrate further has an interconnection region surrounding the multiple photosensitive regions, and a surface of the interconnection region is provided with multiple interconnection lines.

In an embodiment, the image sensor further includes: a second protective layer located on surfaces of the multiple interconnection lines; where a thickness of the second protective layer ranges from 50 nm to 300 nm; and a material of the second protective layer includes silicon.

In an embodiment, the image sensor further includes: a second packaging structure located on a surface of the first protective layer, where the second packaging structure has a groove for carrying a to-be-tested sample.

In an embodiment, a material of the optical filter film includes a metal oxide or a non-metal oxide, the metal oxide includes titanium oxide, zirconium oxide, or aluminum oxide, the non-metal oxide includes silicon oxide, and a thickness of the optical filter film ranges from 5 µm to 20 µm.

In an embodiment, a material of the first protective layer includes silicon dioxide, titanium dioxide, or zirconium dioxide, and a thickness of the first protective layer ranges from 5 nm to 20 nm.

In an embodiment, the preset wavelength of the optical signal allowed to pass through the optical filter film ranges from 488 nm to 700 nm, and preset wavebands of the optical signal allowed to pass through the optical filter film includes a light wavelength greater than 488 nm, a light wavelength greater than 520 nm, or a light wavelength greater than 660 nm.

Compared with the conventional technology, the technical solution of embodiments of the present disclosure has the following beneficial effects:

In the image sensor of the technical solution of the present disclosure, on the one hand, by providing the optical filter film, optical signals of a specific fluorescence waveband can be obtained, facilitating subsequent fluorescence imaging experiments using said fluorescence waveband. On the other hand, the optical filter film is located on the photosensitive regions with a flat surface, such that the optical filter film has a uniform thickness throughout. This reduces the possibility of diffuse reflection and scattering of fluorescence signals on the surface of the optical filter film caused by non-uniform thickness of the optical filter film. While realizing lens-free imaging of fluorescence signals, reducing the cost of fluorescence microscopic detection, and simplifying the fluorescence microscopic detection process, the reliability of fluorescence microscopic detection results is ensured.

Furthermore, the image sensor further includes a fiber optic plate microstructure located between the optical filter film and the first protective layer. The fiber optic plate microstructure enables fluorescence signals to be incident on surfaces of the photosensitive regions in a vertical direction, reducing the possibility of scattering of fluorescence signals, enabling the light intensity collected by the photosensitive regions to be uniform, thereby ensuring the reliability of fluorescence microscopic detection.

In the method for forming an image sensor of the technical solution of the present disclosure, on the one hand, by providing the optical filter film, optical signals of a specific fluorescence waveband can be obtained, facilitating subsequent fluorescence imaging experiments using said fluorescence waveband, thereby realizing lens-free imaging of fluorescence signals, reducing the cost of fluorescence microscopic detection, and simplifying the fluorescence microscopic detection process. On the other hand, the optical filter film is located on the photosensitive regions with a flat surface, such that the optical filter film has a uniform thickness throughout. This reduces the possibility of diffuse reflection and scattering of fluorescence signals on the surface of the optical filter film caused by non-uniform thickness of the optical filter film, and reduces the possibility of large differences in light intensity collected by the photosensitive regions due to diffuse reflection and scattering, and ensures the reliability of fluorescence microscopic detection results.

Furthermore, when the substrate is a wafer, the method for acquiring the substrate includes: performing corresponding semiconductor processing on the wafer to form the multiple photosensitive regions. When the substrate is a discrete chip substrate, the method for acquiring the substrate includes: purchasing an existing product and removing the microlens structure of the existing product. On the one hand, the production cost is reduced; on the other hand, forming the optical filter film on surfaces of the photosensitive regions enhances the bonding force between the optical filter film and the surfaces of the photosensitive regions.

Furthermore, after forming the optical filter film and before forming the first protective layer, the method further includes: forming the fiber optic plate microstructure on the surface of the optical filter film. The fiber optic plate microstructure enables fluorescence signals to be incident on the surfaces of the photosensitive regions in a vertical direction, reducing the possibility of scattering of fluorescence signals, enabling the light intensity collected by the photosensitive regions to be uniform, and ensuring the reliability of fluorescence microscopic detection.

### BRIEF DESCRIPTION OF THE DRAWINGS

Hereinafter accompanying drawings used in the description of embodiments or the conventional technology are briefly introduced, in order to illustrate technical solutions in the embodiments of the present disclosure or the conventional technology more clearly. Apparently, the drawings in the following description are merely some embodiments of the present disclosure, and those skilled in the art can also obtain other drawings according to these drawings without creative efforts.
FIG. 1 is a schematic flow chart of a method for acquiring an image sensor according to an embodiment of the present disclosure.
FIG. 2 is a schematic flow chart of a method for acquiring a substrate according to an embodiment of the present disclosure.
FIG. 3 is a schematic flow chart of a method for acquiring a substrate according to another embodiment of the present disclosure.
FIGS. 4 to 12 are schematic structural diagrams of a forming process of an image sensor according to an embodiment of the present disclosure.

### DETAILED DESCRIPTION OF EMBODIMENTS

As described in the background, the conventional technology still has many problems. In an image sensor of an embodiment, on the one hand, a CMOS image sensor itself has a complete packaging structure; on the other hand, a surface of the CMOS image sensor has certain microstructures, on which it is difficult to produce an optical filter film layer, making it difficult to realize lens-free detection of fluorescence signals.

To solve the above technical problem, a method for forming an image sensor is provided according to the technical solution of the present disclosure. On the one hand, by providing the optical filter film, optical signals of a specific fluorescence waveband can be obtained, facilitating subsequent fluorescence imaging experiments using said fluorescence waveband, thereby realizing lens-free imaging of fluorescence signals, reducing the cost of fluorescence microscopic detection, and simplifying the fluorescence microscopic detection process. On the other hand, the optical filter film is located on the photosensitive regions with a flat surface, such that the optical filter film has a uniform thickness throughout. This reduces the possibility of diffuse reflection and scattering of fluorescence signals on the surface of the optical filter film caused by non-uniform thickness of the optical filter film, and reduces the possibility of large differences in light intensity collected by the photosensitive regions due to diffuse reflection and scattering, and ensures the reliability of fluorescence microscopic detection results.

To make the above objects, features, and beneficial effects of the present disclosure more comprehensible, hereinafter specific embodiments of the present disclosure are described in detail in conjunction with the accompanying drawings.

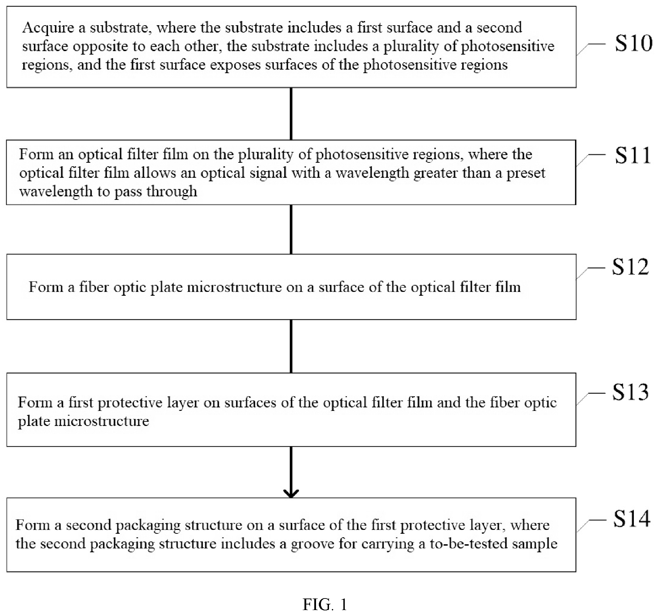

FIG. 1 is a schematic flow chart of a method for acquiring an image sensor according to an embodiment of the present disclosure.

Reference is made to FIG. 1, the method for acquiring the image sensor includes the following steps:
Step S10: acquiring a substrate, where the substrate includes a first surface and a second surface opposite to each other, the substrate includes a plurality of photosensitive regions, and the first surface exposes surfaces of the photosensitive regions;
Step S11: forming an optical filter film on the plurality of photosensitive regions, where the optical filter film allows an optical signal with a wavelength greater than a preset wavelength to pass through;
Step S12: forming a fiber optic plate microstructure on a surface of the optical filter film;
Step S13: forming a first protective layer on surfaces of the optical filter film and the fiber optic plate microstructure; and
Step S14: after forming the first protective layer, forming a second packaging structure on a surface of the first protective layer, where the second packaging structure includes a groove for carrying a to-be-tested sample.

The following is a detailed description with reference to the accompanying drawings.

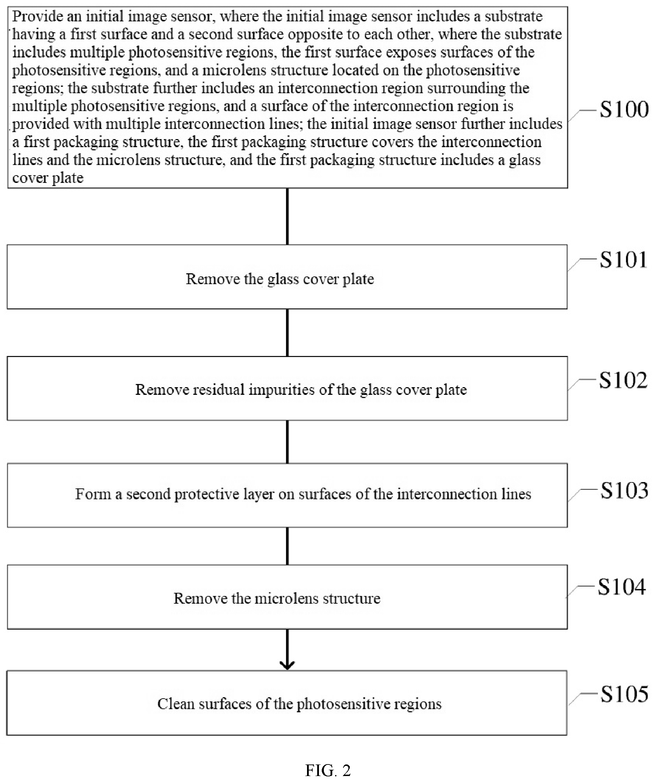

FIG. 2 is a schematic flow chart of a method for acquiring a substrate according to an embodiment of the present disclosure.

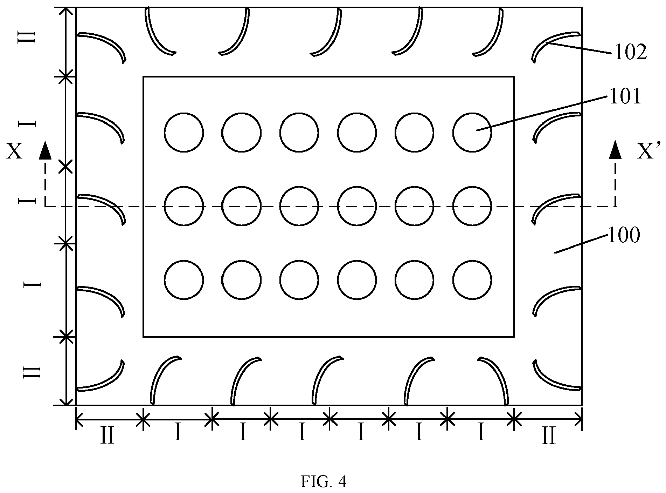

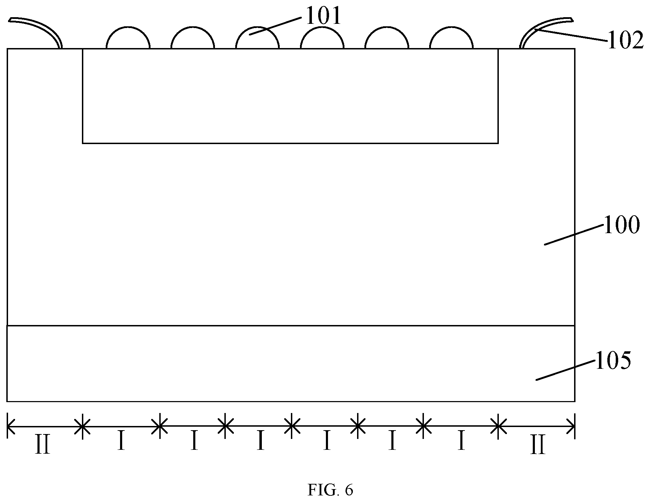

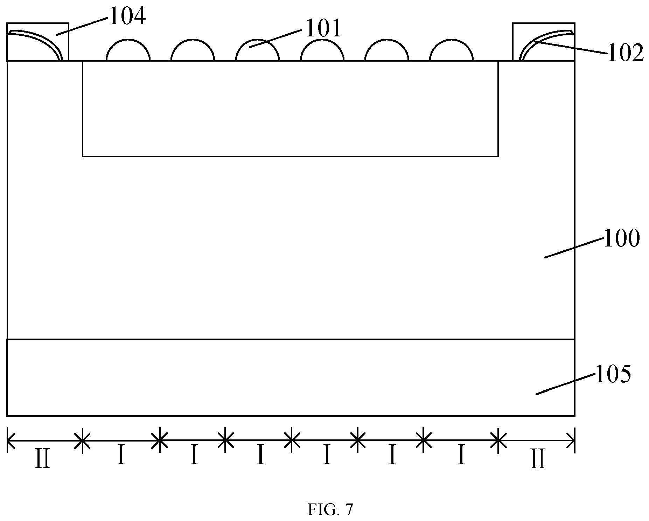

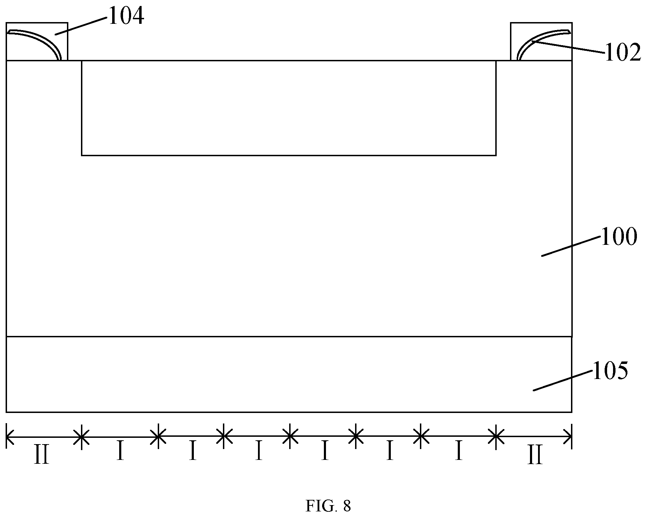

FIGS. 4 to 12 are schematic structural diagrams of a forming process of an image sensor according to an embodiment of the present disclosure.

Reference is made to FIG. 1, Step S10 is performed to obtain a substrate 100, the substrate 100 includes a first surface and a second surface opposite to each other, the substrate 100 includes multiple photosensitive regions I, and the first surface exposes surfaces of the photosensitive regions I.

Specifically, in an embodiment, the substrate 100 is a discrete chip substrate. Reference is made to FIGS. 1 and 2, the method for acquiring the substrate 100 includes the following steps:
Step S100: providing an initial image sensor, where the initial image sensor includes the substrate having a first surface and a second surface opposite to each other, where the substrate includes multiple photosensitive regions, the first surface exposes surfaces of the photosensitive regions, and a microlens structure located on the photosensitive regions; the substrate further includes an interconnection region surrounding the multiple photosensitive regions, and a surface of the interconnection region is provided with multiple interconnection lines; the initial image sensor further includes a first packaging structure, the first packaging structure covers the interconnection lines and the microlens structure, and the first packaging structure includes a glass cover plate;
Step S101: removing the glass cover plate;
Step S102: removing residual impurities of the glass cover plate;
Step S103: forming a second protective layer on surfaces of the interconnection lines;
Step S104: removing the microlens structure;
Step S105: cleaning surfaces of the photosensitive regions.

Detailed description is given below with reference to the accompanying drawings.

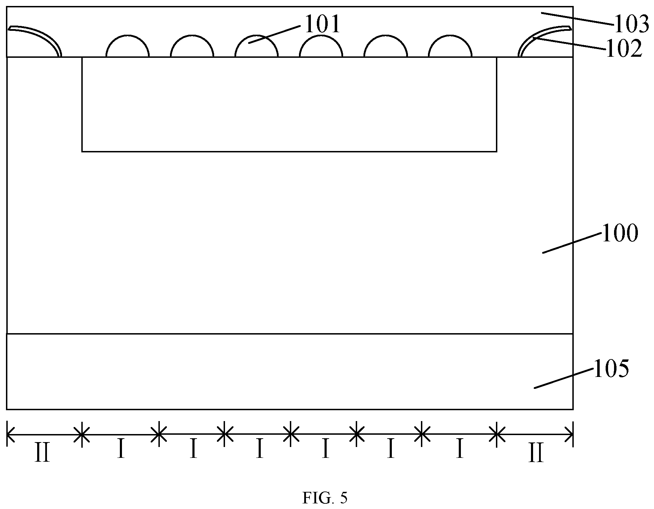

Reference is made to FIGS. 1, 2, 4, and 5, FIG. 4 is a top view of FIG. 5, and FIG. 5 is a cross-sectional structural diagram of FIG. 4 along a direction XX'. The first packaging structure is not shown in the top view. Step S100 is performed to provide an initial image sensor. The initial image sensor includes the substrate 100 having a first surface and a second surface opposite to each other, the substrate 100 includes multiple photosensitive regions I, the first surface exposes surfaces of the photosensitive regions I, and a microlens structure 101 located on the photosensitive regions I.

A material of the substrate 100 includes silicon, silicon carbide, silicon germanium, silicon on insulator (SOI), or germanium on insulator (GOI).

The photosensitive regions I are arranged in an array along a second direction and a first direction, and the first direction is perpendicular to the second direction.

The photosensitive regions I are configured to collect optical signals.

A dimension of the photosensitive regions I in a direction parallel to a surface of the substrate 100 ranges from 5 mm to 30 mm.

The photosensitive regions I provide a structural basis for forming an optical filter film 106.

The substrate 100 further includes an interconnection region II surrounding the multiple photosensitive regions I, and a surface of the interconnection region II is provided with multiple interconnection lines 102.

The interconnection lines 102 are configured to connect a wafer and pins, so as to realize electrical signal transmission and power transfer between an inside and an outside of a chip.

A material of the interconnection lines 102 includes copper, gold, or platinum.

The initial image sensor further includes a first packaging structure, the first packaging structure covers the interconnection lines 102 and the microlens structure 101, and the first packaging structure includes a glass cover plate 103.

In an embodiment, a packaging manner of the first packaging structure includes ceramic leaded chip carrier (CLCC) packaging.

In other embodiments, the first packaging structure adopts other packaging manners.

The initial image sensor further includes a device layer 105.

Specifically, in an embodiment, the device layer 105 is located on the second surface of the substrate 100, and the optical filter film 106 formed subsequently is located on the first surface of the substrate 100.

In other embodiments, the device layer is further located on the first surface of the substrate, and the optical filter film formed subsequently is located on a surface of the device layer.

Specifically, in an embodiment, an existing discrete chip is purchased and a microlens structure 101 of the existing discrete chip is removed. On the one hand, the production cost is reduced; on the other hand, forming the optical filter film 106 on surfaces of the photosensitive regions I enhances the bonding force between the optical filter film 106 and surfaces of the photosensitive regions I.

Reference is made to FIGS. 1, 2, and 6, Step S101 is performed to remove the glass cover plate 103 (as shown in FIG. 5).

The method for removing the glass cover plate 103 includes mechanical removal or thermal processing removal.

The removal of the glass cover plate 103 is performed in a clean room.

Reference is made to FIGS. 1, 2, and 6, Step S102 is performed to remove residual impurities of the glass cover plate 103 after removing the glass cover plate 103. Specifically, in an embodiment, a high-purity gas is used to clean the surface of the substrate 100, so as to remove residual impurities. The high-purity gas includes high-purity nitrogen, high-purity oxygen, or high-purity compressed air.

When removing the glass cover plate 103, the photosensitive regions I are not damaged, so as to avoid impairing the photosensitive regions I and affecting the performance of the image sensor.

When removing the glass cover plate 103, the interconnection lines 102 are not damaged, so as to avoid affecting electrical signal transmission and power transfer between the inside and the outside of the chip.

After removing the glass cover plate 103, the surface of the image sensor is observed to confirm the size of the microlens structure 101 on the surface of the image sensor. The observation is performed using an ordinary microscope or a scanning electron microscope. The purpose of the observation is to determine the size of the microlens structure 101. When the size of the microlens structure 101 is greater than a first threshold, the microlens structure 101 is subsequently removed by mechanical grinding followed by chemical etching or chemical mechanical polishing. When the size of the microlens structure 101 is smaller than the first threshold, the microlens structure 101 is removed by chemical etching or chemical mechanical polishing.

Specifically, in an embodiment, the magnitude of the first threshold is 200 nm. In other embodiments, the magnitude of the first threshold may be other values.

Reference is made to FIGS. 1, 2, and 7, Step S103 is performed to form a second protective layer 104 on surfaces of the interconnection lines 102 after removing the glass cover plate 103.

The second protective layer 104 is high-temperature resistant and corrosion resistant, and a method for forming the second protective layer 104 includes curing. A material of the second protective layer 104 includes UV curable adhesive, thermal curable adhesive, chemical reaction curable adhesive, and natural curable adhesive.

A thickness of the second protective layer 104 ranges from 50 nm to 300 nm.

The function of the second protective layer 104 is: on the one hand, to prevent damage to the interconnection lines 102 that would affect the electrical signal transmission and power transfer between the inside and the outside of the chip; on the other hand, to prevent reagents of the to-be-tested sample from contacting the interconnection lines 102 to form a short circuit and damage the chip.

In other embodiments, the second protective layer is formed after forming the first protective layer.

Reference is made to FIGS. 1, 2, and 8, Step S104 is performed to remove the microlens structure 101 after forming the second protective layer 104.

The method for removing the microlens structure 101 includes one or a combination of mechanical grinding, chemical etching, or chemical mechanical polishing.

When the size of the microlens structure 101 is greater than the first threshold, the method for removing the microlens structure 101 includes: mechanically grinding the microlens structure 101; and chemically etching or chemically mechanically polishing the mechanically ground microlens structure 101 until the surfaces of the photosensitive regions I are exposed.

When the size of the microlens structure 101 is smaller than the first threshold, the method for removing the microlens structure 101 includes: chemically etching or chemically mechanically polishing the microlens structure 101 until the surfaces of the photosensitive regions I are exposed.

Specifically, in an embodiment, the magnitude of the first threshold is 200 nm. In other embodiments, the magnitude of the first threshold may be other values.

The existence of the microlens structure 101 prevents the subsequent optical filter film 106 from being formed on the flat-surfaced photosensitive regions I, resulting in non-uniform thickness of the optical filter film 106. Removing the microlens structure 101 enables the subsequent optical filter film 106 to be formed on the flat-surfaced photosensitive regions I, resulting in a uniform thickness throughout the optical filter film 106. This reduces the possibility of diffuse reflection and scattering of fluorescence signals on the surface of the optical filter film 106 caused by non-uniform thickness of the optical filter film 106, reduces the possibility of large differences in light intensity collected by the photosensitive regions I due to diffuse reflection and scattering, and ensures the reliability of fluorescence microscopic detection results.

Reference is made to FIGS. 1, 2, and 8, Step S105 is performed to clean the surfaces of the photosensitive regions I after removing the microlens structure 101.

The cleaning of the surfaces of the photosensitive regions I is performed in a clean room, and a cleaning solvent includes one or a combination of sodium hydroxide, hydrochloric acid, ethanol, and isopropanol.

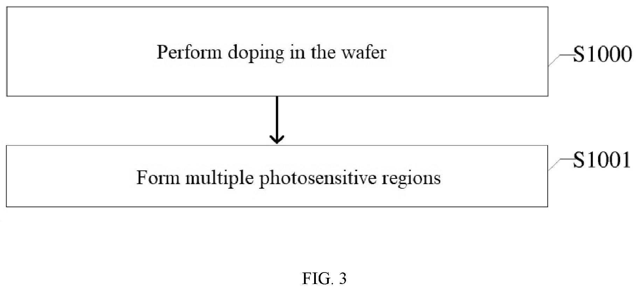

In another embodiment, the substrate is a wafer. Reference is made to FIGS. 1 and 3, the method for acquiring the substrate includes the following steps:
Step S1000: performing corresponding semiconductor processes on the wafer;
Step S1001: forming multiple photosensitive regions.

When the substrate is a wafer, in an embodiment, the device layer is subsequently formed on the first surface of the substrate; and the optical filter film is formed on a surface of the device layer.

When the substrate is a wafer, in another embodiment, the device layer is subsequently formed on the second surface of the substrate; and the optical filter film is formed on the first surface of the substrate.

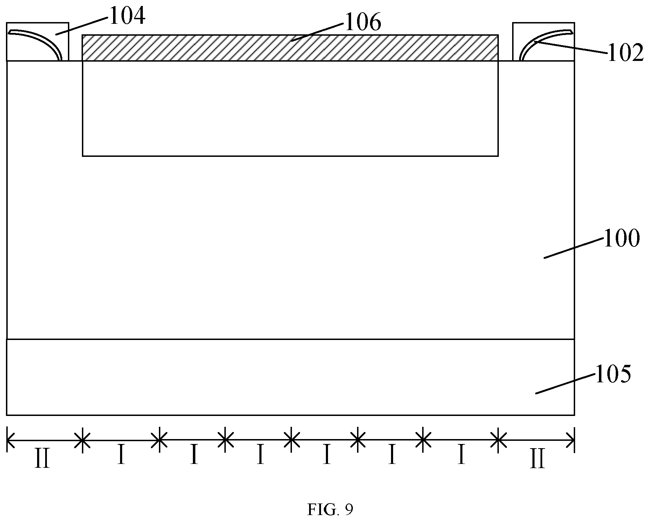

After acquiring the substrate 100, referring to FIGS. 1 and 9, Step S11 is performed. In an embodiment, the optical filter film 106 is formed on the first surface of the substrate 100.

The method for forming the optical filter film 106 includes: acquiring parameters of the optical filter film 106; and forming the optical filter film 106 using the parameters of the optical filter film 106.

The method for acquiring the parameters of the optical filter film 106 includes: acquiring a required optical waveband, where optical parameters of the optical waveband include an excitation light source wavelength peak and an excitation light source wavelength bandwidth; acquiring an optical filter film material; and acquiring the parameters of the optical filter film based on the optical filter film material and the optical parameters.

The method for acquiring the required optical waveband includes: acquiring a wavelength of a fluorescent dye required for detection to acquire the required optical waveband.

The fluorescent dye includes fluorescein or quantum dots; and a wavelength of the fluorescent dye ranges from 468 nm to 508 nm (488+/-20 nm).

The preset wavelength of the optical signals allowed to pass through the optical filter film 106 ranges from 488 nm to 700 nm.

The preset wavebands of the optical signals allowed to pass through the optical filter film 106 include a light wavelength greater than 488 nm, a light wavelength greater than 520 nm, or a light wavelength greater than 660 nm.

In an embodiment, the optical filter film 106 is a long-pass optical filter film.

A material of the optical filter film 106 includes a metal oxide or a non-metal oxide; where the metal oxide includes titanium oxide, zirconium oxide, or aluminum oxide; the non-metal oxide includes silicon oxide.

The method for acquiring the parameters of the optical filter film 106 includes: using simulation software to obtain the parameters of the optical filter film 106 by inputting a preset wavelength of optical signals allowed to pass through. The simulation software includes Zemax, Comsol, or FDTD solutions.

The parameters of the optical filter film 106 include a number of layers of the optical filter film and a thickness of the optical filter film.

The number of layers of the optical filter film 106 ranges from 10 layers to 20 layers; and a thickness of the optical filter film 106 ranges from 5 µm to 20 µm.

The method for forming the optical filter film 106 includes spin coating of light-absorbing dye, magnetron sputtering of target material, or vapor deposition.

Equipment for forming the optical filter film 106 includes one or a combination of a plasma surface treatment machine, a spin coater, a magnetron sputtering apparatus, or a vacuum drying oven.

The optical filter film 106 is provided to obtain optical signals of a specific fluorescence waveband, facilitating subsequent fluorescence imaging experiments using such fluorescence waveband, thereby realizing lens-free imaging of fluorescence signals, reducing the cost of fluorescence microscopic detection, and simplifying the fluorescence microscopic detection process.

After forming the optical filter film 106, the method further includes: performing test characterization on the optical filter film 106. The test characterization includes uniformity test of the optical filter film 106 and spectral transmittance test of the optical filter film 106.

Contents of the uniformity test of the optical filter film 106 include flatness test and roughness test of the optical filter film 106.

A test standard for the spectral transmittance test of the optical filter film 106 is that the optical filter film 106 has a spectral transmittance of greater than 95%.

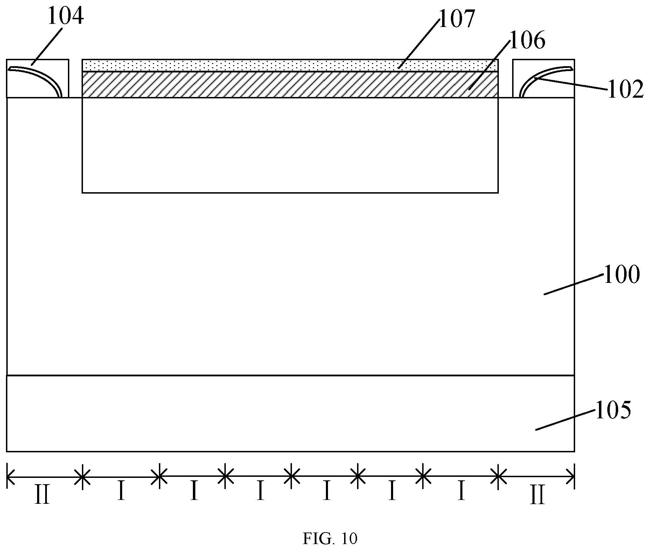

Reference is made to FIGS. 1 and 10, Step S12 is performed to form an fiber optic plate microstructure 107 on a surface of the optical filter film 106 after forming the optical filter film 106.

The method for forming the fiber optic plate microstructure 107 includes:

The material of the fiber optic plate microstructure 107 includes:. forming an initial fiber optic plate microstructure (not shown) on the surface of the optical filter film 106; and performing a micro-nano processing on the initial fiber optic plate microstructure to form the fiber optic plate microstructure 107.

A thickness of the fiber optic plate microstructure 107 ranges from 50 nm to 100 nm.

A dimension of the fiber optic plate microstructure 107 in a direction parallel to a surface of the substrate 100 ranges from 5 mm to 30 mm.

The fiber optic plate microstructure 107 serves to enable fluorescence signals to be incident on surfaces of the photosensitive regions I in a vertical direction, which reduces the possibility of scattering of fluorescence signals, enables the light intensity collected by the photosensitive regions I to be uniform, and ensures the reliability of fluorescence microscopic detection.

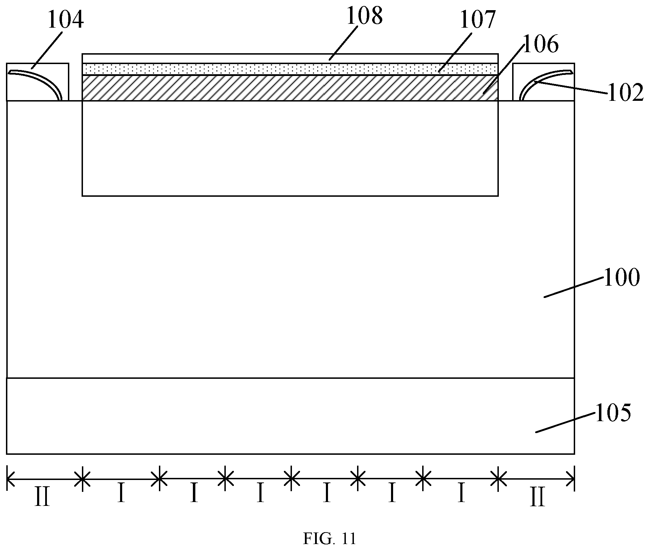

Reference is made to FIGS. 1 and 11, Step S13 is performed to form a first protective layer 108 on a surface of the fiber optic plate microstructure 107 after forming the fiber optic plate microstructure 107.

A material of the first protective layer 108 includes silicon dioxide, titanium dioxide, or zirconium dioxide.

A thickness of the first protective layer 108 ranges from several micrometers to more than ten micrometers.

The first protective layer 108 serves to protect the optical filter film 106 and the fiber optic plate microstructure 107 from damage.

After forming the first protective layer 108, the method further includes: performing test characterization on the optical filter film 106. The test characterization includes: cutoff efficiency of the optical filter film 106 for a corresponding wavelength of light and overall uniformity of the optical filter film 106.

A test standard for the cutoff efficiency of the optical filter film 106 for the corresponding wavelength of light is that the optical filter film 106 has a cutoff efficiency of greater than 99.9%.

Contents of the overall uniformity test of the optical filter film 106 include flatness test of the optical filter film 106 and roughness test of the optical filter film 106.

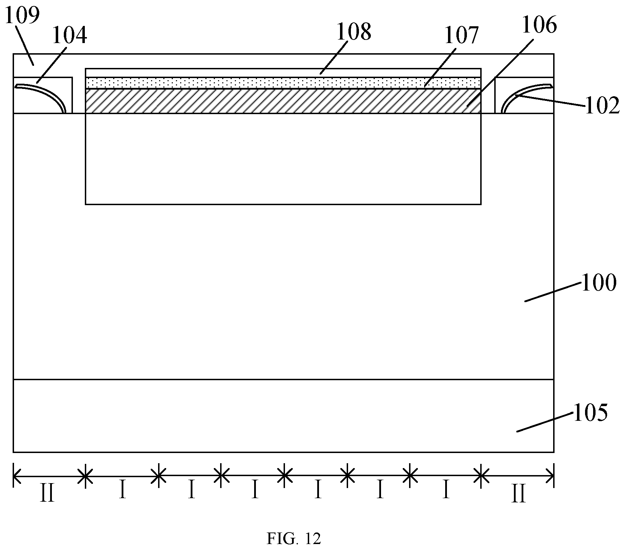

Reference is made to FIGS. 1 and 12, Step S14 is performed to form a second packaging structure 109 on a surface of the first protective layer 108 after forming the first protective layer 108, and the second packaging structure 109 includes a groove (not shown) for carrying a to-be-tested sample.

A material of the second packaging structure 109 includes silicon and quartz glass.

A depth of the groove ranges from 20 µm to 100 µm.

Correspondingly, an image sensor is further provided according to an embodiment of the present disclosure. Reference is made to FIG. 12, the image sensor includes: a substrate 100, where the substrate 100 includes a first surface and a second surface opposite to each other, the substrate 100 includes multiple photosensitive regions I, and the first surface exposes the surfaces of the photosensitive regions I; an optical filter film 106 located on the photosensitive regions I, where the optical filter film 106 allows an optical signal with a wavelength greater than a preset wavelength to pass through; and a first protective layer 108 located on a surface of the optical filter film 106.

The image sensor includes a substrate 100, where the substrate 100 includes a first surface and a second surface opposite to each other, the substrate 100 includes multiple photosensitive regions I, and the first surface exposes the surfaces of the photosensitive regions I.

A material of the substrate 100 includes silicon, silicon carbide, silicon germanium, silicon on insulator (SOI), or germanium on insulator (GOI).

The photosensitive regions I are arranged in an array along a second direction and a first direction, and the first direction is perpendicular to the second direction.

A dimension of the photosensitive regions I in a direction parallel to a surface of the substrate 100 ranges from 5 mm to 30 mm.

The substrate 100 further includes an interconnection region II surrounding the multiple photosensitive regions I, and a surface of the interconnection region II is provided with multiple interconnection lines 102.

A material of the interconnection lines 102 includes copper, gold, or platinum.

The image sensor includes a second protective layer 104 located on surfaces of the interconnection lines 102. A thickness of the second protective layer 104 ranges; and a material of the second protective layer 104 includes UV curable adhesive, thermal curable adhesive, chemical reaction curable adhesive, and natural curable adhesive.

The image sensor includes an optical filter film 106 located on the photosensitive regions I, and the optical filter film 106 allows an optical signal with a wavelength greater than a preset wavelength to pass through.

The preset wavelength of the optical signals allowed to pass through the optical filter film 106 ranges from 488 nm to 700 nm.

The preset waveband of the optical signals allowed to pass through the optical filter film 106 includes a light wavelength greater than 488 nm, a light wavelength greater than 520 nm, or a light wavelength greater than 660 nm.

A material of the optical filter film 106 includes a metal oxide or a non-metal oxide; where the metal oxide includes titanium oxide, zirconium oxide, or aluminum oxide; the non-metal oxide includes silicon oxide.

A number of layers of the optical filter film 106 ranges from 10 layers to 20 layers; and a thickness of the optical filter film 106 ranges from 5 µm to 20 µm.

The image sensor includes a first protective layer 108 located on a surface of the optical filter film 106.

A material of the first protective layer 108 includes silicon dioxide, titanium dioxide, or zirconium dioxide; and a thickness of the first protective layer 108 ranges from several micrometers to more than ten micrometers.

The image sensor includes a fiber optic plate microstructure 107 located between the optical filter film 106 and the first protective layer 108. A material of the fiber optic plate microstructure 107 includes silicon dioxide or titanium dioxide. A thickness of the fiber optic plate microstructure 107 ranges from 50 nm to 100 nm; and a dimension of the fiber optic plate microstructure 107 in a direction parallel to a surface of the substrate 100 ranges from 5 mm to 30 mm.

The image sensor includes a second packaging structure 109 located on a surface of the first protective layer 108, and the second packaging structure 109 includes a groove (not shown) for carrying a to-be-tested sample.

A material of the second packaging structure 109 includes silicon and quartz glass.

A depth of the groove ranges from 20 µm to 100 µm.

In an embodiment, the image sensor further includes a device layer 105 located on the second surface of the substrate 100.

In other embodiments, the image sensor includes a device layer located on the first surface of the substrate; and the optical filter film is located on a surface of the device layer.

Although the present disclosure is disclosed as above, the present disclosure is not limited thereto. Those skilled in the art can make various changes and modifications without departing from the spirit and scope of the present disclosure. Therefore, the protection scope of the present disclosure shall be defined by the claims.

## Claims

1. An image sensor, comprising:
a substrate, wherein the substrate comprises a first surface and a second surface opposite to each other, the substrate comprises a plurality of photosensitive regions, and the first surface exposes surfaces of the plurality of photosensitive regions;
an optical filter film located on the plurality of photosensitive regions, wherein the optical filter film allows an optical signal with a wavelength greater than a preset wavelength to pass through; and
a first protective layer located on a surface of the optical filter film.

2. The image sensor according to claim 1, further comprising a device layer located on the first surface of the substrate or on the second surface of the substrate; wherein the optical filter film is located on a surface of the device layer.

3. The image sensor according to claim 1, further comprising a fiber optic plate microstructure located between the optical filter film and the first protective layer; wherein a material of the fiber optic plate microstructure comprises silicon dioxide or titanium dioxide, and a thickness of the fiber optic plate microstructure ranges from 50 nm to 100 nm.

4. The image sensor according to claim 1, wherein the substrate further has an interconnection region surrounding the plurality of photosensitive regions, and a surface of the interconnection region is provided with a plurality of interconnection lines.

5. The image sensor according to claim 4, further comprising a second protective layer located on surfaces of the plurality of interconnection lines; wherein a thickness of the second protective layer ranges from 50 nm to 300 nm; and a material of the second protective layer comprises silicon.

6. The image sensor according to claim 1, further comprising a second packaging structure located on a surface of the first protective layer, wherein the second packaging structure has a groove for carrying a to-be-tested sample.

7. The image sensor according to claim 1, wherein a material of the optical filter film comprises a metal oxide or a non-metal oxide, the metal oxide comprises titanium oxide, zirconium oxide, or aluminum oxide, the non-metal oxide comprises silicon oxide, and a thickness of the optical filter film ranges from 5 µm to 20 µm.

8. The image sensor according to claim 1, wherein a material of the first protective layer comprises silicon dioxide, titanium dioxide, or zirconium dioxide, and a thickness of the first protective layer ranges from 5 nm to 20 nm.

9. The image sensor according to claim 1, wherein the preset wavelength of the optical signal allowed to pass through the optical filter film ranges from 488 nm to 700 nm, and preset wavebands of the optical signal allowed to pass through the optical filter film comprise a light wavelength greater than 488 nm, a light wavelength greater than 520 nm, or a light wavelength greater than 660 nm.

10. A method for forming an image sensor, comprising:
acquiring a substrate, wherein the substrate comprises a first surface and a second surface opposite to each other, the substrate comprises a plurality of photosensitive regions, and the first surface exposes surfaces of the photosensitive regions;
forming an optical filter film on the plurality of photosensitive regions, wherein the optical filter film allows an optical signal with a wavelength greater than a preset wavelength to pass through; and
forming a first protective layer on a surface of the optical filter film.

11. The method for forming an image sensor according to claim 10, wherein the substrate is a wafer substrate, and the method for acquiring the substrate comprises: performing corresponding semiconductor process development on the wafer substrate to form the plurality of photosensitive regions.

12. The method for forming an image sensor according to claim 10, wherein the substrate is a discrete chip substrate, and the method for acquiring the substrate comprises: providing an initial image sensor, wherein the initial image sensor comprises the substrate, wherein the substrate comprises a first surface and a second surface opposite to each other, the substrate comprises a plurality of photosensitive regions, the first surface exposes surfaces of the plurality of photosensitive regions; and a microlens structure located on the plurality of photosensitive regions; and removing the microlens structure.

13. The method for forming an image sensor according to claim 11, further comprising: forming a device layer on the first surface or the second surface of the substrate; and forming the optical filter film on a surface of the device layer.

14. The method for forming an image sensor according to claim 12, further comprising: a device layer located on the first surface or the second surface of the substrate; and forming the optical filter film on a surface of the device layer.

15. The method for forming an image sensor according to claim 12, wherein the substrate further comprises an interconnection region surrounding the plurality of photosensitive regions, and a surface of the interconnection region is provided with a plurality of interconnection lines.

16. The method for forming an image sensor according to claim 15, wherein the initial image sensor further comprises a first packaging structure covering the plurality of interconnection lines and the microlens structure, and the first packaging structure comprises a glass cover plate.

17. The method for forming an image sensor according to claim 16, wherein before removing the microlens structure, the method further comprises: removing the glass cover plate; wherein the method for removing the glass cover plate comprises mechanical removal or thermal processing removal.

18. The method for forming an image sensor according to claim 17, wherein after removing the glass cover plate and before removing the microlens structure, the method further comprises: forming a second protective layer on surfaces of the plurality of interconnection lines.

19. The method for forming an image sensor according to claim 18, wherein after removing the glass cover plate and before forming the second protective layer, the method further comprises: removing residual impurities of the glass cover plate.

20. The method for forming an image sensor according to claim 12, wherein the method for removing the microlens structure comprises one or a combination of mechanical grinding, chemical etching, and chemical mechanical polishing.

21. The method for forming an image sensor according to claim 12, wherein after removing the microlens structure and before forming the optical filter film, the method further comprises: cleaning surfaces of the plurality of photosensitive regions.

22. The method for forming an image sensor according to claim 10, wherein the method for forming the optical filter film comprises: acquiring parameters of the optical filter film; and forming the optical filter film using the parameters of the optical filter film.

23. The method for forming an image sensor according to claim 22, wherein the method for acquiring the parameters of the optical filter film comprises:
acquiring a required optical waveband, wherein optical parameters of the optical waveband comprise an excitation light source wavelength peak and an excitation light source wavelength bandwidth;
acquiring an optical filter film material; and
acquiring the parameters of the optical filter film based on the optical filter film material and the optical parameters, wherein the parameters of the optical filter film comprise a number of layers of the optical filter film and a thickness of the optical filter film.

24. The method for forming an image sensor according to claim 10, wherein the method for forming the optical filter film comprises spin coating of light-absorbing dye, magnetron sputtering of target material, or vapor deposition.

25. The method for forming an image sensor according to claim 10, wherein after forming the optical filter film and before forming the first protective layer, the method further comprises: forming a fiber optic plate microstructure on the surface of the optical filter film.

26. The method for forming an image sensor according to claim 25, wherein the method for forming the fiber optic plate microstructure comprises: forming an initial fiber optic plate microstructure on the surface of the optical filter film; and performing a micro-nano processing on the initial fiber optic plate microstructure to form the fiber optic plate microstructure.

27. The method for forming an image sensor according to claim 10, wherein after forming the first protective layer, the method further comprises: forming a second packaging structure on a surface of the first protective layer, wherein the second packaging structure comprises a groove for carrying a to-be-tested sample.
